Europäisches Patentamt

European Patent Office

Office européen des brevets

(19)

(11) **EP 0 771 501 B1**

(12) **EUROPÄISCHE PATENTSCHRIFT**

(45) Veröffentlichungstag und Bekanntmachung des Hinweises auf die Patenterteilung:
**18.11.1998 Patentblatt 1998/47**

(21) Anmeldenummer: **95925729.6**

(22) Anmeldetag: **18.07.1995**

(51) Int Cl.⁶: **H04L 25/06**

(86) Internationale Anmeldenummer:
**PCT/DE95/00978**

(87) Internationale Veröffentlichungsnummer:
**WO 96/03826 (08.02.1996 Gazette 1996/07)**

(54) **VERFAHREN ZUM ERFASSEN DER NULLDURCHGÄNGE EINES DATENSIGNALS**

DATA SIGNAL ZERO CROSSING DETECTION PROCESS

PROCEDE DE DETECTION DES PASSAGES PAR ZERO DE SIGNAUX DE DONNEES

(84) Benannte Vertragsstaaten:
**DE FR GB**

(30) Priorität: **21.07.1994 DE 4426712**

(43) Veröffentlichungstag der Anmeldung:
**07.05.1997 Patentblatt 1997/19**

(73) Patentinhaber: **TEKTRONIX, INC.**
**Wilsonville, Oregon 97070-1000 (US)**

(72) Erfinder: **MÄRZ, Freimut**
**D-85764 Oberschleissheim (DE)**

(74) Vertreter: **Hofstetter, Alfons J., Dr.rer.nat. et al**
**Strasse & Hofstetter,**
**Balanstrasse 57**
**81541 München (DE)**

(56) Entgegenhaltungen:
**WO-A-92/14322        US-A- 4 590 600**
**US-A- 4 759 035**

• **JOURNAL OF LIGHTWAVE TECHNOLOGY, Bd. 7, Nr. 11, November 1989 NEW YORK,US, Seiten 1634-1640, XP 000103999 KAWAI 'smart optical reciever'**

**Beschreibung**

Die Erfindung bezieht sich auf ein Verfahren zum Erfassen der Nulldurchgänge eines Datensignals mittels eines Komparators.

Ein solches Verfahren ist beispielsweise aus dem Buch von U. Tietze/Ch. Schenk "Halbleiter-Schaltungstechnik", 3. Auflage, 1976, Seite 296 und 297 bekannt. Bei diesem bekannten Verfahren wird ein Differenzverstärker an einem Eingang mit einer Referenzspannung und an einem weiteren Eingang mit einer zu überwachenden Eingangsspannung beaufschlagt. Da bei diesem bekannten Verfahren am Ausgang des Differenzverstärkers eine maximale Spannung auftritt, wenn die Eingangsspannung größer als die Referenzspannung ist, und sich eine minimale Ausgangsspannung ergibt, wenn die Eingangsspannung kleiner als die Referenzspannung ist, läßt sich durch den Wechsel der Ausgangsspannung ein Nulldurchgang der Eingangsspannung erfassen, wenn die Referenzspannung entsprechend gewählt ist.

Das bekannte Verfahren läßt sich zur genauen Ermittlung der Nulldurchgänge eines Datensignals dann nicht ohne weiteres einsetzen, wenn das Datensignal über ein System mit Filterverhalten übertragen worden ist. Ein solches System liegt beispielsweise bei symmetrischen Leitungen in der Kommunikationstechnik vor, bei denen üblicherweise Übertrager verwendet werden. Durch die Übertrager ergibt sich ein Hochpaßverhalten. Dies führt dazu, daß auch bei Datensignalen mit konstantem Signalpegel die einzelnen übertragenen Impulse eine mehr oder weniger ausgeprägte Dachschräge aufweisen; jeweils am Ende der Dachschräge der einzelnen Impulse des Datensignals setzt der volle Hub des nächsten Impulses des Datensignals auf, so daß es wegen der nicht zu vernachlässigenden Anstiegszeit der einzelnen Impulse des Datensignals nicht möglich ist, den Nulldurchgang mit einem Komparator mit einer festen Schwelle exakt zu erfassen. Es ergibt sich dann ein vom Dateninhalt abhängiger und daher zufälliger Phasenjitter, der bei exakten Messungen nicht zu vernachlässigen ist und daher unterdrückt werden muß.

Der Erfindung liegt daher die Aufgabe zugrunde, ein Verfahren zum Erfassen der Nulldurchgänge eines Datensignals mittels eines Komparators vorzuschlagen, mit dem sich Nulldurchgänge des Datensignals exakt erfassen lassen.

Zur Lösung dieser Aufgabe wird erfindungsgemäß eine dem halben Differenzwert von ermitteltem Maximal- und ermitteltem Minimalwert des Datensignals entsprechende Hilfsspannung erzeugt und durch Vergleich einer zur Hilfsspannung proportionalen Bezugsgröße mit dem jeweiligen Augenblickswert des Datensignals eine Zusatzspannung gebildet, deren Verlauf ein offsetartiges Verändern des Datensignals wiedergibt; die Hilfs- und die Zusatzspannung werden unter Bildung einer Summenspannung addiert, die zur Bildung der Bezugsspannung des Komparators herangezogen wird.

Es ist zwar aus der Zeitschrift "Journal of Lightwave Technology", Bd. 7, Nr. 11, November 1989, Seiten 1634-1640 eine Anordnung bekannt, mit der im Rahmen einer Datenregenerierung ein Schwellenwert selbsttätig eingestellt wird, jedoch weist diese Anordnung insgesamt drei Entscheidungsbausteine auf, mit denen eine Überprüfung eines Eingangssignals auf einen mittleren Schwellenwert, einen um eine vorbestimmte Abweichung höheren Schwellenwert und einen um eine vorbestimmte Abweichung niedrigeren Schwellenwert erfolgt; mittels zweier den Entscheidungsbausteinen nachgeordneter Abweichungs-Erfassungsschaltungen wird über einen diesen nachgeordneten Steuersignalgenerator ein Schwellenwertgeber so gesteuert, daß die Anzahl der von den Abweichungs-Erfassungsschaltungen abgegebenen Impulse gleich groß ist, wodurch ein dem jeweiligen Eingangssignal angepaßter mittlerer Schwellenwert eingestellt wird.

Der wesentliche Vorteil des erfindungsgemäßen Verfahrens besteht darin, daß die Bezugsspannung des verwendeten Komparators offsetartigen Veränderungen des zeitlichen Verlaufs des Datensignals angepaßt wird, also eine feste Bezugsspannung für den Komparator nicht benutzt wird. Ein weiterer Vorteil des erfindungsgemäßen Verfahrens besteht darin, daß es sich mit vergleichsweise geringem Aufwand durchführen läßt, weil zur Bildung der Bezugsspannung lediglich eine in einfacher Weise erzeugbare Hilfsspannung und die Zusatzspannung gebildet werden müssen.

Die Hilfsspannung kann entsprechend einem ermittelten Spitze-Spitze-Wert des Datensignals erzeugt werden oder eine feste vorgegebene Spannung sein. Wird das erfindungsgemäße Verfahren bei Meßanordnungen eingesetzt, die aus anderen Gründen schon mit einem Rechner ausgerüstet sind, dann wird die Hilfsspannung vorteilhafterweise mittels des Rechners mit nachgeordnetem Digital-Analog-Wandler erzeugt.

Bei dem erfindungsgemäßen Verfahren kann auch die Zusatzspannung in unterschiedlicher Weise erzeugt werden. Als besonders vorteilhaft wird es jedoch angesehen, wenn zur Bildung der Zusatzspannung ein Hilfskomparator eingangsseitig einerseits mit der Bezugsgröße und andererseits mit dem Datensignal beaufschlagt; eine Abtast-Halte-Schaltung wird zur Abtastung des Datensignals freigegeben, wenn das Datensignal die Bezugsgröße unterschreitet, und unter Bildung der Zusatzspannung durch einen Impuls eines Systemtaktes gesperrt.

Bei einer vorteilhaften Ausgestaltung des erfindungsgemäßen Verfahrens werden zum Erfassen von Nulldurchgängen von Datensignalen mehrstufiger Codes mit vollem Signalhub ein weiterer und ein zusätzlicher Komparator verwendet, die an jeweils einem Eingang mit dem Datensignal beaufschlagt werden und von denen der weitere Komparator auf eine vorgegebene untere Schwelle und der zusätzliche Komparator auf eine vorgegebene obere Schwelle für die Datensignale eingestellt ist; dem weiteren Komparator wird an seinem anderen Eingang als Bezugsspannung eine Differenzspannung aus der Summenspannung und einer zur Hilfsspannung proportionalen Referenzgröße zugeführt, und dem zusätzlichen Komparator wird an seinem anderen Eingang als Bezugsspannung eine der Summe aus der Summenspannung und der Bezugsgröße entsprechende Spannung zugeführt, und dem weiteren Komparator ist eine erste Zeitstufe und dem einen Komparator eine zweite Zeitstufe nachgeordnet, wobei die mit der ersten Zeitstufe eingestellte Zeitdauer kürzer als die Dauer eines Datensignals und die mit der zweiten Zeitstufe eingestellte Zeitdauer kürzer als die Zeitdauer der ersten Zeitstufe aber länger als die maximal zu erwartende Anstiegszeit eines Datensignals ist; den beiden Zeitstufen und dem zusätzlichen Komparator ist ein gemeinsames UND-Glied zum Gewinnen eines Auslösesignals nachgeschaltet und dem gemeinsamen UND-Glied ist eine zusätzliche Zeitstufe nachgeordnet, die beim Abfall des Auslösesignals an ihrem Ausgang ein dem jeweiligen relevanten Datensignal entsprechendes Auswerte-Signal abgibt.

Eine derartige Ausgestaltung des erfindungsgemäßen Verfahrens ist beispielsweise mit Vorteil anwendbar bei der Phasenjittermessung von Datensignalen mehrstufiger binärer Codes, wie sie beispielsweise als ternäre oder quarternäre Codes in ISDN (Integrated Services Digital Network)-Netzen Verwendung finden. Da ISDN-Datensignale nicht sehr steile Flanken aufweisen, kann nicht ohne weiteres beim Nulldurchgang der Datensignale die Jittermessung vorgenommen werden, weil sich ohne weitere Vorkehrungen nicht reproduzierbare Meßergebnisse einstellen würden. Deshalb werden aus den Datensignalen diejenigen Datensignale als relevante Datensignale erfaßt, die über den durch den jeweiligen Code vorgegebenen vollen Signalhub verlaufen. Bei diesen relevanten Datensignalen können mit dieser Ausgestaltung des erfindungsgemäßen Verfahrens die Nulldurchgänge der ansteigenden Flanken genau erfaßt werden.

Um relevante Datensignale hinsichtlich der abfallenden Flanken untersuchen zu können, werden bei einer anderen vorteilhaften. Ausführungsform des erfindungsgemäßen Verfahrens zum Erfassen von Nulldurchgängen von Datensignalen mehrstufiger Codes mit vollem Signalhub ein weiterer und ein zusätzlicher Komparator verwendet, die an jeweils einem Eingang mit dem Datensignal beaufschlagt werden und von denen der weitere Komparator auf eine vorgegebene untere Schwelle und der zusätzliche Komparator auf eine vorgegebene obere Schwelle für die Datensignale eingestellt ist; dem weiteren Komparator wird an seinem anderen Eingang als Bezugsspannung eine Differenzspannung aus der Summenspannung und der einer zur Hilfsspannung proportionalen Referenzgröße zugeführt, und dem zusätzlichen Komparator wird an seinem anderen Eingang als Bezugsspannung eine der Summe aus der Summenspannung und der Bezugsgröße entsprechende Spannung zugeführt; dem zusätzlichen Komparator ist eine dritte Zeitstufe und dem einen Komparator eine Zeitschaltung nachgeordnet, wobei die mit der dritten Zeitstufe eingestellte Zeitdauer kürzer als die Dauer eines Datensignals und die mit der Zeitschaltung eingestellte Zeitdauer kürzer als die Zeitdauer der dritten Zeitstufe aber länger als die maximal zu erwartende Abfallzeit eines Datensignals ist; der dritten Zeitstufe und der Zeitschaltung sowie dem weiteren Komparator ist eine gemeinsame UND-Schaltung zum Gewinnen eines Auslösesignals nachgeschaltet und der gemeinsamen UND-Schaltung ist eine zusätzliche Zeitstufe nachgeordnet, die beim Abfall des Auslösesignals an ihrem Ausgang ein dem jeweiligen relevanten Datensignal entsprechendes Auswerte-Signal abgibt.

Häufig ist es notwendig bzw. vorgeschrieben, die relevanten Datensignale hinsichtlich ihrer ansteigenden und abfallenden Flanken gemeinsam untersuchen zu können. Dieser Anforderung wird eine weitere vorteilhafte Ausführung des erfindungsgemäßen Verfahrens gerecht, bei der ausgehend von der erfindungsgemäßen Schaltungsanordnung zur Auswertung ansteigender Flanken zum Erfassen von Nulldurchgängen von Datensignalen mehrstufiger Codes mit vollem Signalhub ein weiterer und ein zusätzlicher Komparator verwendet werden, die an jeweils einem Eingang mit dem Datensignal beaufschlagt werden und von denen der weitere Komparator auf eine vorgegebene untere Schwelle und der zusätzliche Komparatzor auf eine vorgegebene obere Schwelle für die Datensignale eingestellt ist; dem weiteren Komparator wird an seinem anderen Eingang als Bezugsspannung eine Differenzspannung aus der Summenspannung und der Bezugsgröße zugeführt, und dem zusätzlichen Komparator wird an seinem anderen Eingang als Bezugsspannung eine der Summe aus der Summenspannung und der Bezugsgröße entsprechende Spannung zugeführt; dem zusätzlichen Komparator ist eine erste Zeitstufe und dem einen Komparator eine Zeitschaltung nachgeordnet, wobei die mit der dritten Zeitstufe eingestellte Zeitdauer kürzer als die Dauer eines Datensignals und die mit der Zeitschaltung eingestellte Zeitdauer kürzer als die Zeitdauer der dritten Zeitstufe aber länger als die maximal zu erwartende Abfallzeit eines Datensignals ist, und der dritten Zeit stufe und der Zeitschaltung sowie dem weiteren Komparator ist eine gemeinsame UND-Schaltung zum Gewinnen eines Auslösesignals nachgeschaltet und der gemeinsamen UND-Schaltung ist eine zusätzliche Zeitstufe nachgeordnet, die beim Abfall des Auslösesignals an ihrem Ausgang ein dem jeweiligen relevanten Datensignal entsprechendes Auswerte-Signal abgibt.

Zur Erläuterung der Erfindung ist in

Figur 1    ein Ausführungsbeispiel einer Anordnung zur Durchführung des erfindungsgemäßen Verfahrens, in

Figur 2    zwei Diagramme zur Erläuterung von Spannungsverläufen und in

Figur 3 ein Ausführungsbeispiel der Auswerte-Schaltung nach Figur 1 wiedergegeben.

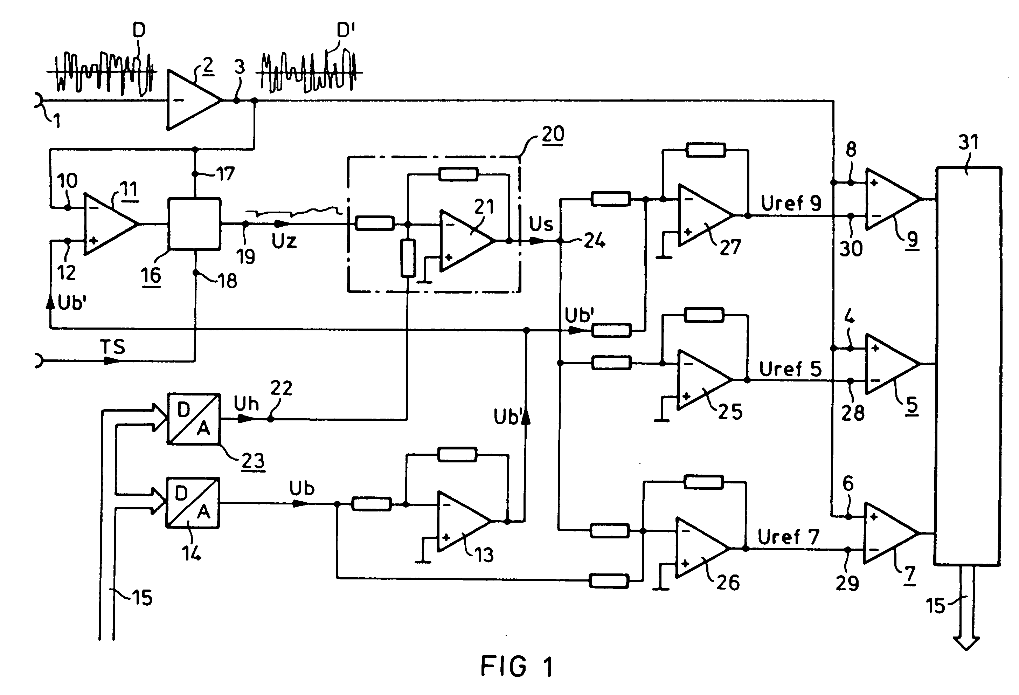

Wie die Figur 1 erkennen läßt, liegt an einem Eingang 1 der dargestellten Anordnung ein Datensignal D, das hinsichtlich seiner Nulldurchgänge zu untersuchen ist und den im Bereich des Eingangs 1 skizzierten zeitlichen Verlauf aufweist. Das Datensignal D wird in einem Invertierer 2 invertiert, so daß an einem Ausgang 3 des Invertierers das ebenfalls in seinem zeitlichen Verlauf dargestellte invertierte Datensignal D' auftritt.

Das invertierte Datensignal D' liegt an einem Eingang 4 eines Komparators 5, an einem Eingang 6 eines weiteren Komparators 7 und an einem Eingang 8 eines zusätzlichen Komparators 9; außerdem ist das invertierte Datensignal D' an einen Eingang 10 eines Hilfskomparators 11 geführt, der an seinem anderen Eingang 12 mit einer Spannung Ub' als Bezugsgröße beaufschlagt ist.

Die Bezugsgröße Ub' wird von einem Operationsverstärker 13 abgegeben, der einem Digital-Analog-Wandler 14 nachgeordnet ist. Dieser Digital-Analog-Wandler 14 ist seinerseits eingangsseitig über einen Bus 15 mit einem nicht dargestellten Rechner verbunden. Aus dem Rechner wird dem Digital-Analog-Wandler 14 ein Digitalwert zugeführt, der der Differenz aus einem ermittelten Maximal- und einem ermittelten Minimalwert des Datensignals D bzw. D' entspricht. Ausgangsseitig gibt der Wandler 14 eine Referenzgröße Ub ab.

Unterschreitet das invertierte Datensignal D' am Eingang 10 des Hilfskomparators 11 den Wert der Bezugsgröße Ub', dann wird eine dem Hilfskomparator 11 nachgeordnete Abtast-Halte-Schaltung 16 zum Abtasten des invertierten Datensignals D' freigegeben, weshalb die Abtast-Halte-Schaltung 16 mit ihrem Eingang 17 an den Ausgang 3 des Invertierers 2 angeschlossen ist. Über einen weiteren Eingang 18 wird die Abtast-Halte-Schaltung 16 von einem Taktsignal TS eines Systemtaktes, beispielsweise abgeleitet aus dem Datensignal D, wieder gesperrt, wodurch am Ausgang 19 der Abtast-Halte-Schaltung 16 eine Zusatzspannung Uz gebildet wird. Diese Zusatzspannung UZ wird in einem Addierer 20 mit einem Operationsverstärker 21 zu einer Hilfsspannung Uh addiert, die am Ausgang 22 eines weiteren Digital-Analog-Wandlers 23 auftritt. Dieser weitere Digital-Analog-Wandler 23 ist ebenfalls über den Bus 15 mit dem nicht dargestellten Rechner verbunden und wird von dem Rechner so beaufschlagt, daß er die Hilfsspannung Uh mit einer Höhe abgibt, die dem halben Differenzwert von ermitteltem Maximal- und ermitteltem Minimalwert des Datensignals D entspricht. Am Ausgang 24 des Addierers 20 ist damit eine Summenspannung Us gebildet, die sich durch folgende Beziehung (1) beschreiben läßt:

$$Us = Uh + Uz \qquad (1)$$

Die Summenspannung Us wird zusammen mit der Bezugsgröße Ub weiteren Addierern mit Operationsverstärkern 25, 26 und 27 zugeführt, die den Komparatoren 5, 7 und 9 vorgeordnet sind. Demzufolge ergibt sich an einem (anderen) Eingang 28 des einen Komparators 5 eine Bezugsspannung, die sich durch folgende Gleichung (2) beschreiben läßt:

$$Uref5 = -(-(Uh + Uz)) = Uh + Uz \qquad (2)$$

Die Bezugsspannungen Uref7 und Uref9 an den jeweils anderen Eingängen 29 bzw. 30 des weiteren Komparators 7 bzw. des zusätzlichen Komparators 9 lassen sich durch die folgenden Gleichungen (3) und (4) beschreiben:

$$Uref7 = -(Ub + (-(Uh + Uz))) = Uh + Uz - Ub \qquad (3)$$

$$Uref9 = -(-Ub + (-(Uh + Uz))) = Uh + Uz + Ub \qquad (4)$$

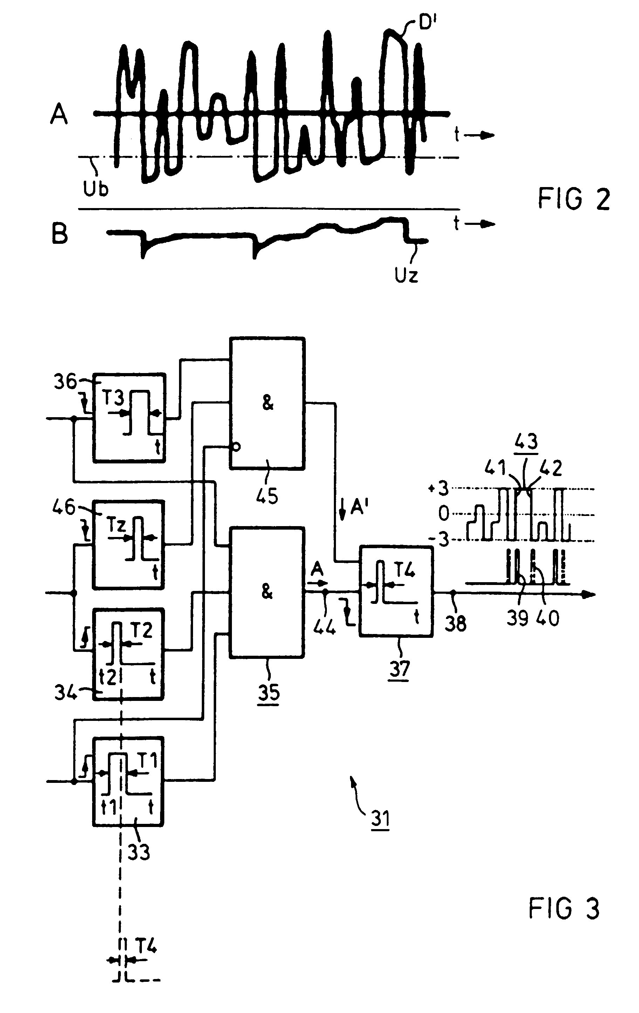

Den Komparatoren 5, 7 und 9 ist eine Auswerte-Schaltung 31 nachgeordnet, die in einem Ausführungsbeispiel in Fig. 3 dargestellt ist.

Zur weiteren Erläuterung der Wirkungsweise der in Figur 1 dargestellten Anordnung wird im folgenden auf die Figur 2 Bezug genommen, in der im Diagramm A der zeitliche Verlauf des invertierten Datensignals D' wiedergegeben ist. In dem Diagramm A ist auch die Bezugsgröße Ub' eingezeichnet. Im Diagramm B der Figur 2 ist über der Zeit t die Zusatzspannung Uz in ihrem zeitlichen Verlauf dargestellt. Das Diagramm B läßt erkennen, daß der Verlauf der Zusatzspannung Uz das offsetartige Verändern des Datensignals D' in bezug auf die Nullinie wiedergibt. Eine Art Offset des Datensignals D' wird also durch eine entsprechend hohe Zusatzspannung Uz erfaßt und bei der Erzeugung der Bezugsspannung für die einzelnen Komparatoren 5, 7 und 9 berücksichtigt, so daß diese mit einer gewissermaßen gleitenden Bezugsspannungsschwelle arbeiten. Die drei Komparatoren 5, 7 und 9 haben daher in bezug auf das Datensignal D bzw. D' immer die gleichen Schaltpunkte, was im Falle einer Phasenjittermessung zu einer hohen Genauigkeit führt.

In Figur 3 ist ein Ausführungsbeispiel der den Komparatoren 5, 7 und 9 nachgeordneten Auswerteschaltung 31 nach Figur 1 wiedergegeben. Die Figur 3 läßt erkennen, daß dem weiteren Komparator 7 eine Zeitstufe 33 und dem einen Komparator 5 eine zweite Zeitstufe 34 nachgeordnet ist. Beide Zeitstufen 33 und 34 sind ausgangsseitig mit einem UND-Glied 35 verbunden, das außerdem direkt an den zusätzlichen Komparator 9 angeschlossen ist.

Ausgangsseitig ist das UND-Glied 35 mit einer zusätzlichen Zeitstufe 37 verbunden, an deren Ausgang 38 Signale 39 und 40 entstehen, die die Nulldurchgänge ansteigender und abfallender Flanken 41 bzw. 42 eines Impulses 43 eines dargestellten ternären Datensignals kennzeichnen.

Die in Figur 3 dargestellte, insoweit beschriebene Auswerte-schaltung arbeitet in folgender Weise:

Soll gerade eine ansteigende Flanke 41 eines relevanten Datensignals 43 zur Phasenjittermessung erfaßt werden, dann wird durch diese Flanke 41 zu einem Zeitpunkt t1 die erste Zeitstufe 33 gestartet. Die mit dieser Zeitstufe eingestellte Zeitdauer T1 ist etwas kürzer als die Zeitdauer des relevanten Datensignals 43. Zu einem etwas späteren Zeitpunkt t2 wird beim Nulldurchgang der Flanke 41 die zweite Zeitstufe 34 gestartet, deren eingestellte Zeitdauer T2 kürzer als die Zeitdauer T1 der ersten Zeitstufe 33 aber länger als die maximal zu erwartende Anstiegszeit des relevanten Datensignals 43 ist. Wenn das relevante Datensignal 43 die obere Schwelle +3 erreicht, wird in einem kurzen Zeitintervall von den beiden Zeitstufen 33 und 34 und vom zusätzlichen Komparator 9 das UND-Glied 35 gemeinsam beaufschlagt. Figur 2 läßt erkennen, daß das daraufhin am Ausgang 44 des UND-Gliedes 35 entstehende Auslösesignal A mit dem Abfall der zweiten Zeitstufe 34 seinerseits abfällt, womit die zusätzliche Zeitstufe 37 gestartet wird. Es entsteht dann das dem relevanten Datensignal 43 entsprechende Auswerte-Datensignal 39, das in den Kurvenverläufen am Ausgang 38 der zusätzlichen Zeitstufe 37 mit durchgehenden Linien eingezeichnet ist.

Figuren 2 und 3 lassen ferner erkennen, daß der weitere Komparator 7 direkt mit einem invertierenden Eingang einer UND-Schaltung 45 verbunden ist; ein weiterer Eingang der UND-Schaltung 45 ist über eine Zeitschaltung 46 mit dem Ausgang des einen Komparators 45 und ein zusätzlicher Eingang der UND-Schaltung 45 ist über eine dritte Zeitstufe 36 mit dem Ausgang des zusätzlichen Komparators 9 verbunden. Beim Abfall des relevanten Datensignals 43 bzw. bei dessen abfallender Flanke 42 wird am Ausgang der UND-Schaltung 45 ein Auslöseimpuls A' erzeugt, auf den hin von der zusätzlichen Zeitstufe 37 das weitere Auswerte-Datensignal 40 abgegeben wird, das am Ausgang 38 der zusätzlichen Zeitstufe 37 strichliert dargestellt ist.

**Patentansprüche**

1. Verfahren zum Erfassen der Nulldurchgänge eines Datensignals mittels eines Komparators,
   **dadurch gekennzeichnet,** daß

   - eine dem halben Differenzwert von ermitteltem Maximal- und ermitteltem Minimalwert des Datensignals (D) entsprechende Hilfsspannung (Uh) erzeugt wird,
   - durch Vergleich einer zur Hilfsspannung (Uh) proportionalen Bezugsgröße (Ub') mit dem jeweiligen Augenblickswert des Datensignals (D) eine Zusatzspannung (Uz) gebildet wird, deren Verlauf ein offsetartiges Verändern des Datensignals (D) wiedergibt,
   - die Hilfs- und die Zusatzspannung (Uh; Uz) unter Bildung einer Summenspannung (Us) addiert werden und
   - die Summenspannung (Us) zur Bildung der Bezugsspannung (Uref5, Uref7, Uref9) des Komparators (5,7,9) herangezogen wird.

2. Verfahren nach Anspruch 1,
   **dadurch gekennzeichnet,** daß

   - die Hilfsspannung (Uh) als fest vorgegebene Spannung mittels eines Rechners mit nachgeordnetem Digital-Analog-Wandler (23) erzeugt wird.

3. Verfahren nach Anspruch 1 oder 2,
   **dadurch gekennzeichnet,** daß

   - zur Bildung der Zusatzspannung (Uz) ein Hilfskomparator (11) eingangsseitig einerseits mit der Bezugsgröße (Ub) und andererseits mit dem Datensignal (D') beaufschlagt wird und
   - eine Abtast-Halte-Schaltung (16) zur Abtastung des Datensignals (D') freigegeben wird, wenn das Datensignal (D') die Bezugsgröße (Ub') unterschreitet, und unter Bildung der Zusatzspannung (Uz) durch einen Impuls eines Systemtaktes (TS) gesperrt wird.

4. Verfahren nach einem der vorangehenden Ansprüche,
   **dadurch gekennzeichnet,** daß

   - zum Erfassen von Nulldurchgängen von Datensignalen (D) mehrstufiger Codes mit vollem Signalhub ein weiterer und ein zusätzlicher Komparator (7;9) verwendet werden, die an jeweils einem Eingang (6;8) mit dem Datensignal (D') beaufschlagt werden und von denen der weitere Komparator (7) auf eine vorgegebene untere Schwelle und der zusätzliche Komparator (9) auf eine vorgegebene obere Schwelle für die Datensignale (D') eingestellt ist,
   - dem weiteren Komparator (7) an seinem anderen Eingang (29) als Bezugsspannung (Uref7) eine Differenzspannung aus der Summenspannung (Us) und einer zur Hilfsspannung (Uh) proportionalen Referenzgröße (Ub) zugeführt wird,
   - dem zusätzlichen Komparator (9) an seinem anderen Eingang (30) als Bezugsspannung (Uref9) eine der Summe aus der Summenspannung (Us) und der Bezugsgröße (Ub) entsprechende Spannung zugeführt wird,
   - dem weiteren Komparator (7) eine erste Zeitstufe (33) und dem einen Komparator (5) eine zweite Zeitstufe (34) nachgeordnet ist, wobei

- die mit der ersten Zeitstufe (33) eingestellte Zeitdauer (T1) kürzer als die Dauer eines Datensignals (D') und die mit der zweiten Zeitstufe (34) eingestellte Zeitdauer (T2) kürzer als die Zeitdauer (T1) der ersten Zeitstufe (33) aber länger als die maximal zu erwartende Anstiegszeit eines Datensignals (D') ist,

- den beiden Zeitstufen (33,34) und dem zusätzlichen Komparator (9) ein gemeinsames UND-Glied (35) zum Gewinnen eines Auslösesignals (A) nachgeschaltet ist und
- dem gemeinsamen UND-Glied (35) eine zusätzliche Zeitstufe (37) nachgeordnet ist, die beim Abfall des Auslösesignals (A) an ihrem Ausgang (38) ein dem jeweiligen relevanten Datensignal (D') entsprechendes Auswerte-Signal (39) abgibt.

5. Verfahren nach einem der Ansprüche 1 bis 3, **dadurch gekennzeichnet,** daß

- zum Erfassen von Nulldurchgängen von Datensignalen (D) mehrstufiger Codes mit vollem Signalhub ein weiterer und ein zusätzlicher Komparator (7;9) verwendet werden, die an jeweils einem Eingang (6;8) mit dem Datensignal (D') beaufschlagt werden und von denen der weitere Komparator (7) auf eine vorgegebene untere Schwelle und der zusätzliche Komparator (9) auf eine vorgegebene obere Schwelle für die Datensignale (D') eingestellt ist,
- dem weiteren Komparator (7) an seinem anderen Eingang (29) als Bezugsspannung (Uref7) eine Differenzspannung aus der Summenspannung (Us) und der einer zur Hilfsspannung (Uh) proportionalen Referenzgröße (Ub) zugeführt wird,
- dem zusätzlichen Komparator (9) an seinem anderen Eingang (30) als Bezugsspannung (Uref9) eine der Summe aus der Summenspannung (Us) und der Bezugsgröße (Ub') entsprechende Spannung zugeführt wird,
- dem zusätzlichen Komparator (9) eine dritte Zeitstufe (36) und dem einen Komparator (5) eine Zeitschaltung (46) nachgeordnet ist, wobei

    - die mit der dritten Zeitstufe (36) eingestellte Zeitdauer (T3) kürzer als die Dauer eines Datensignals (D') und die mit der Zeitschaltung (46) eingestellte Zeitdauer (T2) kürzer als die Zeitdauer (T3) der dritten Zeitstufe (36) aber länger als die maximal zu erwartende Abfallzeit eines Datensignals (D') ist,

- der dritten Zeitstufe (36) und der Zeitschaltung (46) sowie dem weiteren Komparator (7) eine gemeinsame UND-Schaltung (45) zum Gewinnen eines Auslösesignals (A') nachgeschaltet ist und
- der gemeinsamen UND-Schaltung (45) eine zusätzliche Zeitstufe (37) nachgeordnet ist, die beim Abfall des Auslösesignals (A') an ihrem Ausgang (38) ein dem jeweiligen relevanten Datensignal (D') entsprechendes Auswerte-Signal (40) abgibt.

6. Schaltungsanordnung zum Erfassen der Nulldurchgänge eines Datensignals

- mit einem Hilfskomparator (11), in dem eine einer dem halben Differenzwert von ermitteltem Maximal- und ermitteltem Minimalwert des Datensignals (D) entsprechenden Hilfsspannung (Uh) proportionale Bezugsgröße (Ub') mit dem jeweiligen Augenblickswert des Datensignals (D) unter Bildung einer Zusatzspannung (Uz) verglichen wird, deren Verlauf ein offsetartiges Verändern des Datensignals (D) wiedergibt,
- mit einem dem Hilfskomparator (11) nachgeordneten Addierer (20), in dem die Hilfs- und die Zusatzspannung (Uh; Uz) unter Bildung einer Summenspannung (Us) addiert werden,
- mit einem dem Addierer (20) nachgeschalteten Komparator (5), der an einem Eingang (4) mit dem Datensignal (D') und an einem weiteren Eingang (28) mit einer unter Heranziehung der Summenspannung (Us) gebildeten Bezugsspannung (Uref5) beaufschlagt ist,
- mit einem jeweils dem Addierer (20) nachgeordneten weiteren und einem zusätzlichen Komparator (7;9), die an jeweils einem Eingang (6;8) mit dem Datensignal (D') beaufschlagt werden und von denen der weitere Komparator (7) auf eine vorgegebene untere Schwelle und der zusätzliche Komparator (9) auf eine vorgegebene obere Schwelle für die Datensignale (D') eingestellt ist,
- mit einer dem weiteren Komparator (7) nachgeordneten ersten Zeitstufe (33) und einer dem einen Komparator (5) nachgeordneten zweiten Zeitstufe (34),
- mit einem den beiden Zeitstufen (33,34) und dem zusätzlichen Komparator (9) nachgeschalteten gemeinsamen UND-Glied (35) zum Gewinnen eines Auslösesignals (A) und
- mit einer dem gemeinsamen UND-Glied (35) nachgeordneten zusätzlichen Zeitstufe (37), die beim Abfall des Auslösesignals (A) an ihrem Ausgang (38) ein dem jeweiligen relevanten Datensignal (D') entsprechendes Auswerte-Signal (39) abgibt,

- mit einer an den zusätzlichen Komparator (9) angeschlossenen dritten Zeitstufe (36) und einer an den einen Komparator (5) angeschlossenen Zeitschaltung (46), wobei

   - die mit der dritten Zeitstufe (36) eingestellte Zeitdauer (T3) kürzer als die Dauer eines Datensignals (D') und die mit der Zeitschaltung (46) eingestellte Zeitdauer (Tz) kürzer als die Zeitdauer (T3) der dritten Zeitstufe (36) aber länger als die maximal zu erwartende Abfallzeit eines Datensignals ist,

- mit einer der dritten Zeitstufe (36) und der Zeitschaltung (46) sowie dem weiteren Komparator (7) nachgeschalteten gemeinsamen UND-Schaltung (45) zum Gewinnen eines Auslöseimpulses (A') und
- mit einer der gemeinsamen UND-Schaltung (45) nachgeordneten zusätzlichen Zeitstufe (37), die beim Abfall des Auslöseimpulses (A') an ihrem Ausgang (38) ein dem jeweiligen relevanten Datensignal (D') entsprechendes Auswerte-Datensignal (40) abgibt.

**Claims**

1. A process for detecting data signal zero crossings by means of a comparator
   **characterized in**
   that

   - an auxiliary voltage (Uh) is generated which corresponds to a value which is half of the difference between the detected maximum and minimum values of the data signal (D),
   - a supplemental voltage (Uz) is formed by comparing a reference magnitude (Ub'), which is proportional to said auxiliary voltage (Uh), with the respective instantaneous value of said data signal (D), with the course of said supplemental voltage rendering an offset-like alteration of said data signal (D),
   - said auxiliary and supplemental voltages (Uh; Uz) are added forming a total voltage (Us), and
   - said total voltage (Us) is used for forming the reference voltage (Uref5, Uref7, Uref9) of said comparator (5, 7, 9).

2. The process of claim 1
   **characterized in**
   that

   - said auxiliary voltage (Uh) is generated as a strictly preset voltage by means of a computer with post-connected digital-to-analog converter (23).

3. The process of claims 1 or 2
   **characterized in**
   that

   - for generating said supplemental voltage (Uz) an auxiliary comparator (11) has its input connected to receive the reference magnitude (Ub) on the one hand, and the data signal (D') on the other hand, and
   - a sample-and-hold circuit (16) is enabled to sample said data signal (D') when said data signal (D') falls below said reference magnitude (Ub') and is blocked by a pulse of a system clock (TS), thereby forming the supplemental voltage (Uz).

4. The process of one of the preceding claims
   **characterized in**
   that

   - for detecting zero crossings of data signals (D) of multilevel codes having a full signal deviation a further as well as an additional comparator (7; 9) are used which receive, at one input each (6; 8) said data signal (D') and of which the further comparator (7) is set to a predetermined lower threshold and the additional comparator (9) is set to a predetermined upper threshold for the data signals (D'),
   - the further comparator (7) receives, at its other input (29), a voltage as the reference voltage (Uref7) which is the difference between the total voltage (Us) and a reference magnitude (Ub), which is proportional to said auxiliary voltage (Uh),
   - the additional comparator (9) receives, at its other input (30), a voltage as the reference voltage (Uref9) which corresponds to the sum of said total voltage (Us) and said reference magnitude (Ub),
   - the further comparator (7) is followed by a first timer (33) and the one comparator (5) is followed by a second timer (34), wherein

      - the time period (T1) set by means of the first timer (33) is shorter than the duration of a data signal (D') and the time period (T2) set by means of the second timer (34) is shorter than the time period (T1) of the first timer (33) but longer than the maximum anticipated rise time of a data signal (D'),

   - post-connected to the two timers (33, 34) and the additional comparator (9) is a common AND gate (35) for obtaining a trigger signal (A), and

- post-connected to the common AND gate (35) is an additional timer (37) which - when the trigger signal (A) drops at its output (38) - outputs an evaluation signal (39) which corresponds to the respective relevant data signal (D').

5. The process of one of claims 1 to 3 **characterized in** that

- for detecting zero crossings of data signals (D) of multilevel codes having a full signal deviation a further as well as an additional comparator (7; 9) are used which receive, at one input each (6; 8) said data signal (D') and of which the further comparator (7) is set to a predetermined lower threshold and the additional comparator (9) is set to a predetermined upper threshold for the data signals (D'),
- the further comparator (7) receives, at its other input (29), a voltage as the reference voltage (Uref7) which is the difference between said total voltage (Us) and a reference magnitude (Ub) which is proportional to said auxiliary voltage (Uh),
- the additional comparator (9) receives, at its other input (30), a voltage as the reference voltage (Uref9) which corresponds to the sum of said total voltage (Us) and said reference magnitude (Ub'),
- the additional comparator (9) is followed by a third timer (36) and the one comparator (5) is followed by a timing circuit (46), wherein

  - the time period (T3) set by means of the third timer (36) is shorter than the duration of a data signal (D') and the time period (T2) set by means of the timing circuit (46) is shorter than the time period (T3) of the third timer (36) but longer than the maximum anticipated decay time of a data signal (D'),

- post-connected to the third timer (36) and the timing circuit (46) as well as the further comparator (7) is a common AND gate (45) for obtaining a trigger signal (A'), and
- post-connected to the common AND gate (45) is an additional timer (37) which - when the trigger signal (A') drops at its output (38) - outputs an evaluation signal (40) which corresponds to the respective relevant data signal (D').

6. A switching arrangement for detecting data signal zero crossings comprising

- an auxiliary comparator (11) in which a reference magnitude (Ub') which is proportional to an auxiliary voltage (Uh) corresponding to a value that is half of the difference between detected maximum and minimum values of the data signal (D) is compared to the respective instantaneous value of the data signal (D), thus forming a supplemental voltage (Uz), with the course of said supplemental voltage rendering an offset-like alteration of said data signal (D),
- an adder (20) which is post-connected to said auxiliary comparator (11), which adder (20) adds said auxiliary and supplemental voltages (Uh; Uz), thus forming a total voltage (Us),
- a comparator (5) post-connected to said adder (20), which comparator (5) receives the data signal (D') at its one input (4) and a reference voltage (Uref5) formed on the basis of said total voltage (Us) at its further input (28),
- a further as well as an additional comparator (7; 9), either being post-connected to said adder (20), said comparators (7; 9) receiving, at one input each (6; 8) the data signal (D'), with the further comparator (7) being set to a predetermined lower threshold and the additional comparator (9) being set to a predetermined upper threshold for the data signals (D'),
- a first timer (33) post-connected to said further comparator (7) and a second timer (34) post-connected to said one comparator (5),
- a common AND gate (35) post-connected to said two timers (33, 34) and said additional comparator (9) for obtaining a trigger signal (A), and
- an additional timer (37) post-connected to said common AND gate (35), which timer (37) - when the trigger signal (A) drops at its output (38) - outputs an evaluation signal (39) corresponding to the respective relevant data signal (D'),
- a third timer (36) connected to said additional comparator (9) as well as a timing circuit (46) connected to said one comparator (5), wherein

  - the time period (T3) set by means of the third timer (36) is shorter than the duration of a data signal (D') and the time period (Tz) set by means of the timing circuit (46) is shorter than the time period (T3) of the third timer (36) but longer than the maximum anticipated decay time of a data signal,

- a common AND gate (45) post-connected to said third timer (36) and said timing circuit (46) as well as said further comparator (7) for obtaining a trigger pulse (A'), and
- an additional timer (37) post-connected to said common AND gate (45), which timer (37) - when the trigger pulse (A') drops at its output (38) - outputs an evaluation data signal (40) which corresponds to the respective relevant data signal (D').

## Revendications

1. Procédé de détection des passages par zéro de signaux de données à l'aide d'un comparateur , **caractérisé en ce que**

   - une tension auxiliaire (Uh) est créée, correspondante à la moitié de la valeur différentielle entre la valeur maximum du signal de donnée (D) déterminée et la valeur minimum déterminée,
   - une tension additionnelle (Uz), dont la courbe apporte une modification offset du signal de données (D), est créée en comparant une grandeur de référence (Ub') proportionnelle à la tension auxiliaire (Uh) avec la valeur instantanée du signal de données (D) respective,
   - les tensions auxiliaire et additionnelle (Uh; Uz) sont additionnées pour former une tension somme (Us) et
   - la tension somme (Us) est utilisée pour créer la tension de référence (Uref5, Uref7, Uref9) du comparateur (5, 7, 9).

2. Procédé suivant la revendication 1, **caractérisé en ce que**

   - la tension auxiliaire (Uh) est fournie comme tension fermement définie à l'aide d'un ordinateur avec convertisseur numérique-analogique (23) subordonné.

3. Procédé suivant les revendications 1 et 2, **caractérisé en ce que**

   - pour créer la tension additionnelle (Uz), un comparateur auxiliaire (11) est alimenté côté entrée d'une part par une grandeur de référence (Ub) et d'autre part par le signal de données (D'), et
   - un échantillonneur-bloqueur (16) est activé pour échantillonner le signal de données (D') quand le signal de données (D') passe en dessous de la grandeur de référence (Ub'), et bloqué par une impulsion de rythme d'horloge (TS) lors de la création de la tension additionnelle (Uz).

4. Procédé suivant l'une des revendications précédentes. **caractérisé en ce que**

   - pour la détection des passages par zéro de signaux de données (D) de codes à plusieurs niveaux dont la déviation de signal est maximale, un deuxième comparateur et un comparateur supplémentaire (7; 9) sont alimentés par le signal de données (D') respectivement à une entrée (6; 8), le deuxième comparateur (7) étant réglé sur un seuil défini inférieur et le comparateur supplémentaire (9) sur un seuil défini supérieur des signaux de données (D'),
   - une tension différentielle issue de la tension somme (Us) et d'une grandeur de référence (Ub) proportionnelle à la tension auxiliaire (Uh) est alimentée en tant que tension de référence (Uref7) à l'autre entrée (29) du deuxième comparateur (7),
   - une tension correspondante à la somme de la tension somme (Us) et de la grandeur de référence (Ub) est alimentée en tant que tension de référence (Uref9) à l'autre entrée (30) du comparateur supplémentaire (9),
   - un premier temporisateur (33) est subordonné au deuxième comparateur (7) et un deuxième temporisateur (34) au premier comparateur (5),

      - l'intervalle de temps (T1) réglé sur le premier temporisateur (33) étant plus court que la durée d'un signal de données (D') et l'intervalle de temps (T2) réglé sur le deuxième temporisateur (34) étant plus court que l'intervalle de temps (T1) du premier temporisateur (33), mais plus long que le temps de montée maximum possible d'un signal de données (D'),

   - une porte ET (35) commune aux deux temporisateurs (33, 34) et au comparateur supplémentaire (9) leur est subordonnées pour l'obtention d'un signal de déclenchement (A) et
   - un temporisateur supplémentaire (37) est subordonné à la porte ET commune (35), délivrant à sa sortie (38), lorsque le signal de déclenchement (A) décline, un signal de repérage (39) correspondant au signal de données caractéristique (D') respectif.

5. Procédé suivant l'une des revendications 1 à 3, **caractérisé en ce que**

   - pour la détection des passages par zéro de signaux de données (D) de codes à plusieurs niveaux dont la déviation de signal est maximale, un deuxième comparateur et un comparateur supplémentaire (7; 9) sont alimentés par le signal de données (D') respectivement à une entrée (6; 8), le deuxième comparateur (7) étant réglé sur un seuil défini inférieur et le comparateur supplémentaire (9) sur un seuil défini supérieur des signaux de données (D'),

- une tension différentielle issue de la tension somme (Us) et d'une grandeur de référence (Ub) proportionnelle à la tension auxiliaire (Uh) est alimentée en tant que tension de référence (Uref7) à l'autre entrée (29) du deuxième comparateur (7),
- une tension correspondante à la somme de la tension somme (Us) et de la grandeur de référence (Ub') est alimentée en tant que tension de référence (Uref9) à l'autre entrée (30) du comparateur supplémentaire (9),
- un troisième temporisateur (36) est subordonné au comparateur supplémentaire (9) et une minuterie (46) au premier comparateur (5),

  - l'intervalle de temps (T3) réglé sur le troisième temporisateur (36) étant plus court que la durée d'un signal de données (D') et l'intervalle de temps (T2) réglé sur la minuterie (46) étant plus court que l'intervalle de temps (T3) du troisième temporisateur (36), mais plus long que le temps de montée maximum possible d'un signal de données (D'),

- une porte ET (45) commune au troisième temporisateur (36) et à la minuterie (46) ainsi qu'au deuxième comparateur (7) leur est subordonnée pour l'obtention d'un signal de déclenchement (A'), et
- un temporisateur supplémentaire (37) est subordonné à la porte ET commune (45), délivrant à sa sortie (38), lorsque le signal de déclenchement (A') décline, un signal de repérage (40) correspondant au signal de données caractéristique (D') respectif.

6. Constitution de circuit pour la détection des passages par zéro de signaux de données

- avec un comparateur auxiliaire (11), dans lequel une grandeur de référence (Ub') proportionnelle à une tension auxiliaire (Uh) correspondante à la moitié de la valeur différentielle entre la valeur maximum et la valeur minimum déterminées du signal de données (D) est comparée à la valeur instantanée pour créer une tension additionnelle (Uz), dont la courbe apporte une modification offset du signal de données (D),
- avec un additionneur (20) subordonné au comparateur auxiliaire (11), dans lequel la tension auxiliaire et la tension additionnelle (Uh; Uz) sont additionnées pour créer une tension somme (Us),
- avec un comparateur (5) placé en aval de l'additionneur (20), alimenté à une entrée (4) par le signal de données (D') et à une autre entrée (28) par une tension de référence (Uref5) créée en utilisant la tension somme (Us),

- avec un deuxième comparateur et un comparateur supplémentaire (7; 9), tous deux subordonnés à l'additionneur (20) et alimentés chacun à une entrée (6, 8) par le signal de données (D'), le deuxième comparateur (7) étant réglé sur un seuil défini inférieur et le comparateur supplémentaire (9) étant réglé sur un seuil défini supérieur des signaux de données (D'),
- avec un premier temporisateur (33) subordonné au deuxième comparateur (7) et un deuxième temporisateur (34) subordonné au premier comparateur (5),
- avec une porte ET (35) subordonnée et commune aux deux temporisateurs (33, 34) et au comparateur supplémentaire (9) pour l'obtention d'un signal de déclenchement (A), et
- avec un temporisateur supplémentaire (37) subordonné à la porte ET commune (35), délivrant à sa sortie (38), lorsque le signal de déclenchement (A) décline, un signal de repérage (39) correspondant au signal de données caractéristique (D') respectif.
- avec un troisième temporisateur (36) connecté au comparateur supplémentaire (9) et une minuterie (46) connectée au premier comparateur (5),

  - l'intervalle de temps (T3) réglé sur le troisième temporisateur (36) étant plus court que la durée d'un signal de données (D') et l'intervalle de temps (Tz) réglé sur la minuterie (46) étant plus court que l'intervalle de temps (T3) du troisième temporisateur (36), mais plus long que le temps de descente maximum possible d'un signal de données,

- avec, pour l'obtention d'un signal de déclenchement (A'), une porte ET (45) subordonnée et commune au troisième temporisateur (36) et à la minuterie (46), ainsi qu'au deuxième comparateur (7), et
- avec un temporisateur supplémentaire (37) subordonné à la porte ET commune (45), délivrant à sa sortie (38), lorsque le signal de déclenchement (A') décline, un signal de repérage (40) correspondant au signal de données caractéristique (D') respectif.

FIG 1

EP 0 771 501 B1

FIG 2

FIG 3